# EUROPEAN PATENT SPECIFICATION

(11) **EP 0 232 093 B1**
(45) Date of publication and mention of the grant of the patent: **17.03.1993**
(21) Application number: 87300607.6
(22) Date of filing: 23.01.1987
(51) Int. Cl.: H03M 13/00, G11B 20/18, G06F 11/10

(54) **Data transmission and recording methods**
Verfahren zur Übertragung und Aufzeichnung von Daten
Méthodes de transmission et d'enregistrement de données

(30) Priority: 24.01.1986 JP 13554/86; 23.04.1986 JP 93892/86
(43) Date of publication of application: 12.08.1987
(73) Proprietor: SONY CORPORATION, Tokyo 141 (JP)
(72) Inventor: Sako, Yoichiro§c/o Patents Division, Shinagawa-ku§Tokyo 141 (JP); Yamamura, Shinichi§Patents Division, Shinagawa-ku§Tokyo 141 (JP); Yamagami, Tamotsu§Patents Division, Shinagawa-ku§Tokyo 141 (JP)
(74) Representative: Pilch, Adam John Michael

(56) References cited:
- EP-A- 0 129 324
- EP-A- 0 156 440
- EP-A- 0 229 698
- GB-A- 2 140 178
- COMPUTER DESIGN, vol. 21, no. 3, March 1982, pages 107-116, Winchester, Mass., US; D. SCHOENE et al.: "Disk file error correction with a PLA"
- IBM TECHNICAL DISCLOSURE BULLETIN, vol. 17, no. 2, July 1974, pages 473-475, New York, US; A.M. PATEL: "Coding scheme for multiple sections error correction"
- IBM TECHNICAL DISCLOSURE BULLETIN, vol. 22, no. 6, November 1979, pages 2365-2368, New York, US; C.L CHEN: "High-speed cyclic redundancy checking scheme for error correcting codes"

## Description

This invention relates to data transmission and recording methods.

It is known to add an error correcting code and an error detecting code to data to be transmitted so as to detect and correct errors occurring in the data while the data is transmitted along a transmission path or to a recording medium. In this technique, the error correcting code (ECC), such as a b-adjacent code, for correcting errors occurring in a predetermined quantity of data to be transmitted, is first produced and then added to the predetermined quantity of data. Next, the error detecting code (EDC) is produced on the basis of the error correcting code and the predetermined quantity of data to be transmitted. Then, the data with the error correcting code and the error detecting code is transmitted along the transmission path (or to the recording medium). The data with the error correcting code and the error detecting code received after transmission via the transmission path is processed to correct a possible error thereof which may occur in the transmitted data. Specifically, the error detecting code is first used to detect whether or not a possible error exists in the received data and the error correcting code is added thereto. If it is detected that any error exists in the received data, the error in the transmitted data is corrected by the use of the error correcting code. That is, the error detecting code is used to check for the existence of an error in the received data before error correction of the received data.

Further, a so-called product code has previously been proposed to correct a possible error in the data. This product code is arranged to produce an error correcting code for each row and column of data of a rectangular array comprising a predetermined quantity of data. A known code, for example a Reed-Solomon code, may be employed as the error correcting code. The data and the error correcting codes are successively transmitted in a predetermined order along the transmission path or to the recording medium. The predetermined quantity of data with the error correcting code received after transmission via the transmission path is once again arranged into a rectangular array. Then, the possible errors in the data are corrected by the use of the error correcting codes generated for the data in each of the row and column directions.

European Patent Application EP-A-0 156 440 discloses a data transmission method using a data format similar to that described above. First and second error correcting Reed-Solomon codes are generated in different directions of a rectangular data array thereby forming a product code. A sector sync signal is provided to indicate the head of each sector, followed by headers indicating recording time, sector number and mode. European Patent Applications EP-A-0 129 324 and EP-A-0 229 698 also describe similar data formats, the latter application having been published after the priority and filing dates of the present application.

However, according to the previously-proposed techniques, the above-mentioned rectangular array of the product code is formed for only one kind of recording medium. Therefore, if the data is to be recorded on a plurality of different types of recording media, each of which has a different data capacity, the data processing procedure cannot be commonly utilised for these different kinds of recording media, and this constitutes a major inconvenience in the processing of the data.

According to the invention there is provided a data transmission or recording method for data formed in a rectangular array of rows and columns comprising a block of data formed of a predetermined number n of words, supplementary data associated with said block of data and an error detecting code to detect possible errors which may occur in said block of data and said supplementary data, said method comprising the steps of:
producing and adding a first error correcting code for and to each row of data of said rectangular array along which said data of n words is sequentially arranged;
producing and adding a second error correcting code for and to each column of data of said rectangular array thereby to form product-coded data from said block of data, said supplementary data, said first error correcting code and said second error correcting code; and
fetching and either transmitting or recording said product-coded data along each said row;
characterised in that:
when said block of data is to be changed in word number from the number n to a selected number m, the number of data in each said column of said rectangular array is varied in response to the change in data word number while the number of data words in each said row is fixed so as to form a new rectangular array of product-coded data; and
the new product-coded data forming said new rectangular array is sequentially fetched and either transmitted or recorded along each said row.

A preferred method, to be described in detail hereinafter, can be commonly utilised when data is recorded on a plurality of different kinds of recording media.

The preferred method is suitable for transmitting blocks of data, each of which comprises a predetermined quantity of data, via a transmission path, or to a recording medium such as a magneto-optical disc having a track which is divided into a plurality of sectors into which the blocks of data are respectively written or recorded.

The invention will now be described by way of example with reference to the accompanying drawings, throughout which like parts are referred to by like references, and in which:
Figure 1A is a diagram showing the formation of a product code according to a first embodiment of the present invention;
Figure 1B is a diagram showing a modification of the product code of Figure 1A in which the quantity of data to be transmitted is different from that shown in Figure 1A;
Figure 2A is a diagram showing the formation of a product code according to a second embodiment of the present invention;
Figure 2B is a diagram showing a modification of the product code of Figure 2A in which the quantity of data to be transmitted is different from that shown in Figure 2A;
Figure 2C is a diagram showing a modification of the product code of Figure 2B;
Figures 3A and 3B together form a diagram showing a sector format in the case where product coded data according to another embodiment of the invention is recorded in each sector of a disc-shaped recording medium; and
Figure 4 is a block diagram showing the construction of apparatus for recording and reproducing product-coded data on a disc-shaped recording medium.

A data transmission method will now be described in which a product code is formed of blocks of data and the product-coded data is successively transmitted via a transmission path. The method is suitable for the case where the quantity of data forming the above block of data may be varied and then transmitted.

Disc-shaped recording media are used for data storage for computers. The disc-shaped recording media can be provided with one spiral track or a plurality of cylindrical or annular tracks, the track or tracks being divided into a plurality of sectors. Examples of this kind of recording medium are floppy discs, magneto-optical discs, worm (write once read many) discs, and the like.

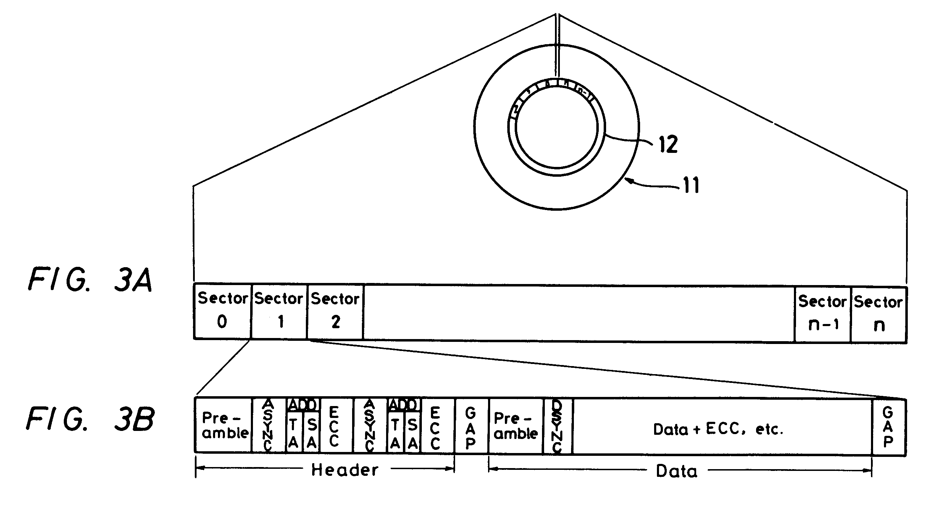

Figures 3A and 3B show an example of a sector format for a magneto-optical disc 11, in which a track 12 formed on the magneto-optical disc 11 is divided into a plurality of sectors in its circumferential direction, on each of which is recorded a predetermined quantity of data with an error correcting code ECC, an error detecting code EDC and other information.

As shown in Figure 3A, one track comprises n+1 sectors (0 to n). In one embodiment, one track is formed of 32 sectors.

A format of data to be recorded on one sector may be arranged, for example, as shown in Figure 3B. Each sector comprises a header portion, a data portion, and gap portions GAP provided at the end of each of the header portion and the data portion.

At the head of the header portion, preamble data is recorded and following that in the header portion there are twice recorded an address signal ADD comprising track address data TA and sector address data SA, each followed by an error correcting code ECC with the first error correcting code ECC followed by an address synchronising signal ASYNC.

In the data portion, preamble data is recorded at the head, followed by a data synchronising signal DSYNC, and data with an error correcting code ECC added.

In one widely-used format, 512 bytes of usable data are recorded in one sector in the track formed on a floppy disc. However, other media, for example a magneto-optical disc, worm disc, or the like, from which data is optically reproduced, have a much larger data capacity than that of the floppy disc. For such mass data storage media, the capacity of one sector, namely the quantity of data which can be recorded in one sector, can be considered to be set at a product value obtained by multiplying 512 bytes by a selected integer, for example 2 thereby providing 1024 bytes, in place of 512 bytes.

Embodiments of the prevent invention provide data transmission methods suitable for the case where data is transmitted to more than two different kinds of media which have different sector capacities, for example set in one case at 512 bytes and in the other case at a product value obtained by multiplying 512 bytes by a certain selected integer.

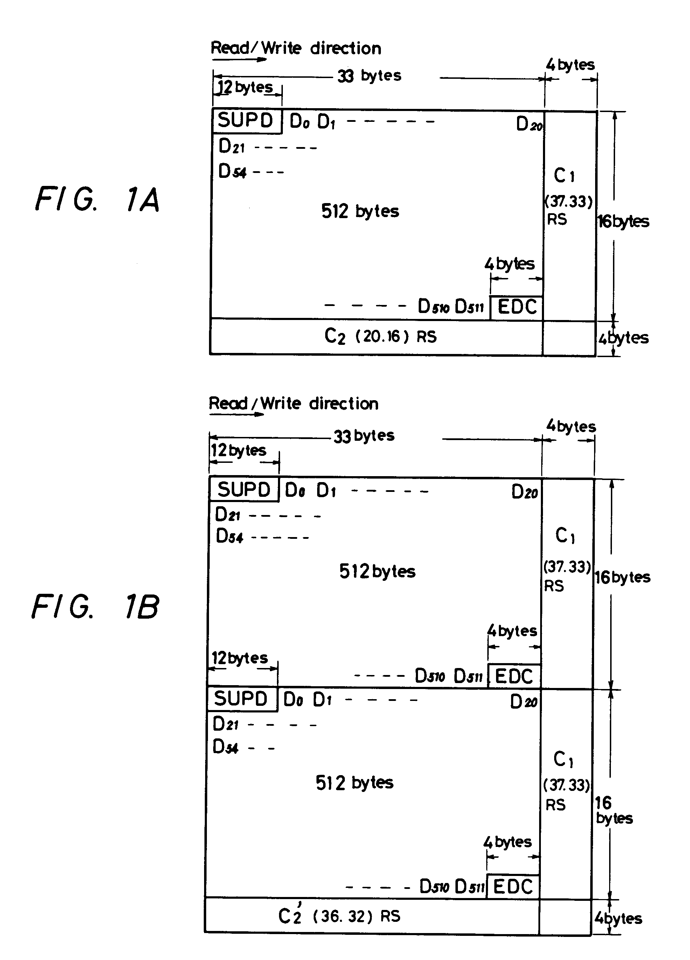

Figures 1A and 1B are diagrams showing examples of the formation of the product codes.

In Figure 1A, 512 bytes of serial data D₀ - D₅₁₁ form a block of data to be transmitted (or recorded). There is also provided supplementary data SUPD having a length of 12 bytes which is required to transmit the 512 bytes of data. The supplementary data SUPD comprises information relative to the data to be transmitted (or recorded), for example information indicative of whether the data is to be processed by, for example, a computer, or is to be processed in real time such as is the case with audio signals, information indicative of a data transmission rate, information indicative of the destination of the data, information indicative of data allocation, for instance track number, sector number, and the like, information indicative of when the data is to be recorded on a disc-shaped recording medium, and information about the link between respective sectors. Further, there is provided an error detecting code EDC formed of 4 bytes, for example in the form of a cyclic redundancy check (CRC) code for detecting possible errors which may occur in the block of 512 bytes of data to be transmitted and the 12-byte supplementary data SUPD. Then, the 512 bytes of data to be transmitted, the 12 bytes of supplementary data SUPD, and the 4 bytes of error detecting code EDC are rearranged in a digital memory of transmitting or recording apparatus (not shown) into the form of a rectangular array which has a 33-byte length in the row direction and a 16-byte length in the column direction. A first error correcting code C₁, for example a (37,33) Reed-Solomon code is produced and added to each 33 bytes of data in the row direction. A second error correcting code C₂, for example a (20,16) Reed-Solomon code is produced and added to each 16 bytes of data in the column direction. Thus, a product code is formed. The product-coded data comprising 740 (37 x 20) bytes is fetched from memory and transmitted to or recorded in each sector of a disc-shaped recording medium, beginning with the data located at the first column and the first row and then successively along the row direction, in the form of serial data. The 740 bytes of serial data thus transmitted or recorded is again transformed into the original product code. Then, possible errors introduced into the product code during transmission are corrected in the row direction and in the column direction respectively by the use of a C₁ parity and a C₂ parity, that is the first and second error correcting codes C₁ and C₂. Next, the 512 bytes of data and the 12 bytes of supplementary data SUPD which are subjected to error correction by the use of the C₁ and the C₂ parities are finally checked by the use of the error detecting code EDC to determine whether or not the data still contains possible errors.

Figure 1B shows the formation of a product code when the capacity of one block of data to be transmitted is increased from 512 bytes to 1024 (512 x 2) bytes. It will be assumed that product-coded data having 1332 (37 x 36) bytes is recorded, for example in each sector of the track on a disc-shaped recording medium.

This increase in the quantity of data contained in one block is dealt with by changing the number of data words in a direction different from the sequential order in which the data is written in the rectangular array. Specifically, in Figure 1B, the quantity of data in the column direction of the rectangular array is increased from 16 bytes to 32 bytes to cope with the increase in the quantity of data. The product code shown in Figure 1B is composed by stacking in memory two 528 byte rectangular arrays each as shown in Figure 1A, and each comprising 512 bytes of data, 12 bytes of supplementary data SUPD, and 4 bytes of error detecting code EDC; then the error correcting codes C₁ and C₂ʹ are produced and added to each of the respective rows and columns of data of the stacked rectangular array.

As shown in Figure 1B, the same (37,33) Reed-Solomon code is used for the C₁ parity as that which was used for the array of Figure 1A, but a (36,32) Reed-Solomon code is used for the C₂ʹ parity. Each of the 12 bytes of supplementary data SUPD contains information indicative of the quantity of data (1024 bytes) contained in one block to be transmitted, information indicative of in which one of the two blocks of each of the 512 bytes of data is located, information indicative of the transmission rate of the data, and the like.

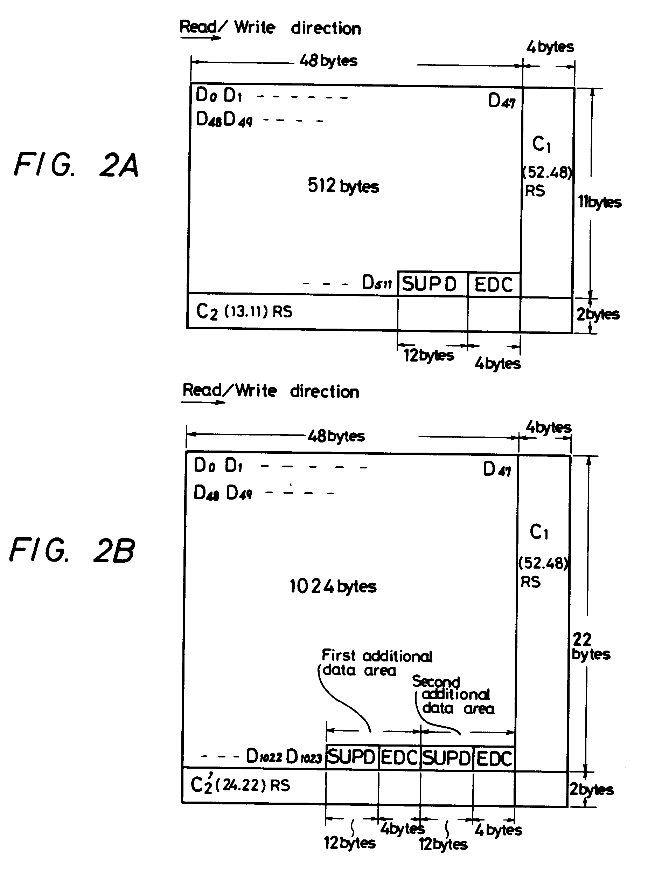

Figures 2A to 2C show the formation of product codes in which the supplementary data SUPD is placed after the data to be transmitted, that is immediately in front of the error detecting code EDC.

Referring to Figure 2A, after the 512 bytes of data to be transmitted, the supplementary data SUPD having 12 bytes is added, the supplementary data SUPD being required to transmit the 512 bytes of data. Further, the 4 bytes of error detecting code EDC, such as a cyclic redundancy check (CRC) code, for detecting possible errors in the 512 bytes of data and in the supplementary data SUPD of 12 bytes is produced and added to the above-mentioned data. The 528 bytes of data is formed into a rectangular array which has a 48-byte length in the row direction and an 11-byte length in the column direction. Then, a C₁ parity having 4 bytes, for example a (52,48) Reed-Solomon code, is produced and added to each row of 48 bytes of data of the rectangular array. Also, a C₂ parity having 2 bytes, for example a (13,11) Reed-Solomon code, is produced and added to each 11 bytes of data arranged in the column direction of the rectangular array. Data in the product code thus formed is successively fetched and transmitted starting from the first column, first row, along the row direction.

Figure 2B shows the formation of a product code in which one block of data to be transmitted is increased from the 512 bytes of Figure 2A to 1024 (512 x 2) bytes. As is clear from Figure 2B, a second block of 512 bytes of data is placed after a first block of 512 bytes of data. Placed after the second block of 512 bytes of data are the 12 bytes of supplementary data SUPD and the error detecting code EDC for the first block of data followed by the supplementary data SUPD and the error detecting code EDC for the second block of data, thereby forming a rectangular array having 1056 (48 x 22) bytes of data. Next, in the same manner as described with reference to Figure 1A, a C₁ parity, for example a (52,48) Reed-Solomon code, is produced and added to each row of the rectangular array of the 48 bytes in the row direction. Then a C₂' parity, for example a (24,22) Reed-Solomon code (different to the C₂ parity of Figure 2A), is produced and added to each column of 22 data bytes of the rectangular array. Finally, a product code having 1248 (52 x 24) bytes is thus produced. The data in the product code is successively fetched and transmitted beginning with the first column, first row and then proceeding along the row direction.

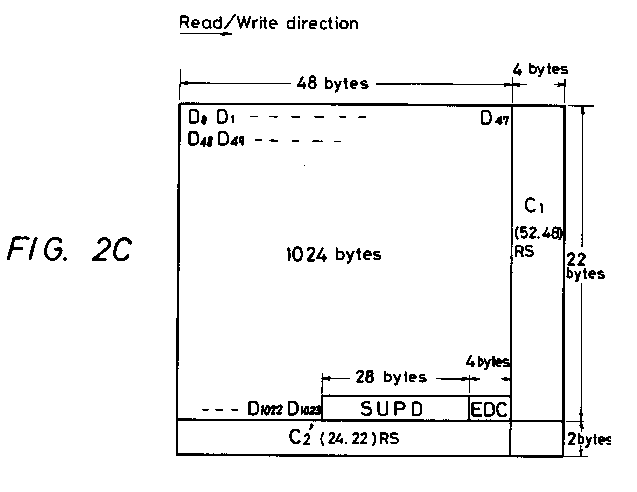

In Figure 2B, the 512 bytes of data is taken as a fundamental unit and the 12 bytes of supplementary data SUPD and the 4 bytes of error detecting code EDC to be added to each block of the 512 bytes of data are located close to each other after the 1024 bytes of data. However, in Figure 2C, 1024 bytes of data is specified as a fundamental unit and, for example, 28 bytes of supplementary data SUPD and 4 bytes of error detecting code EDC are produced to detect the possible errors in the former. In this case, a rectangular array having a 48-byte row length and a 22-byte column length is produced. Therefore, in Figure 2C the number of data words in the row direction is the same as that of the rectangular array shown in Figure 2A while the number of data words in the column direction is increased. Note that the same C₁ parity can be used for each array.

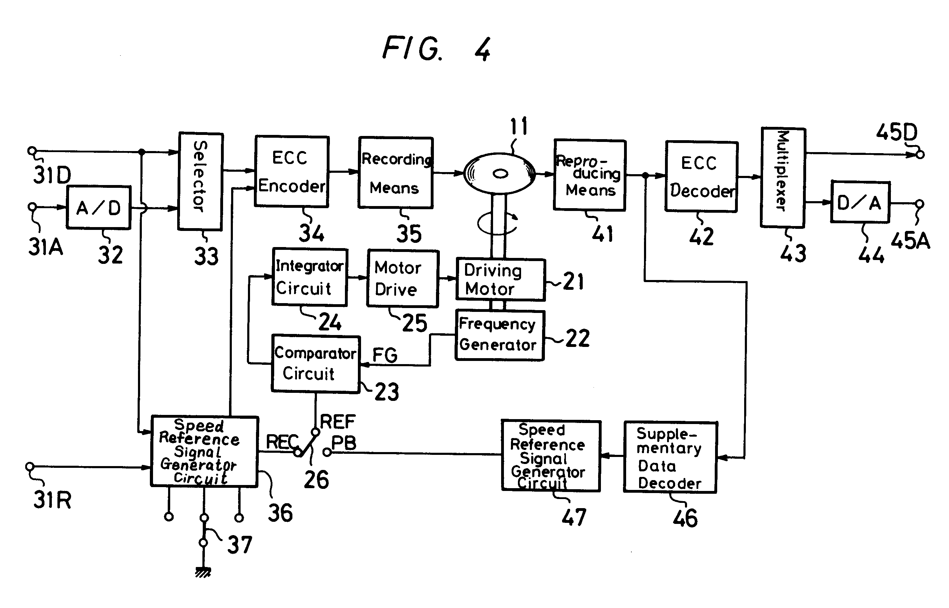

Figure 4 is a block diagram showing the construction of a recording and reproducing apparatus for recording the above-described product-coded data on a disc-shaped recording medium, and for reproducing the data therefrom.

Referring to Figure 4, a magneto-optical recording disc 11 includes, for example, a spiral-shaped track (not shown) on which the above data is recorded. A recording and reproducing head (not shown) in the apparatus is controlled such that the head correctly scans the previously-formed track.

A disc driving motor 21 is arranged to control the disc 11 such that the disc 11 is rotated at a predetermined speed, in other words at a constant angular velocity. The driving motor 21 is provided with a frequency generator 22 which generates a frequency signal FG proportional to the rotational speed of the driving motor 21. The frequency signal FG is supplied to a phase comparator circuit 23. The phase comparator circuit 23 is also supplied with one of two speed reference signals REF selected by a switch 26. Although this speed reference signal REF can be varied according to the transmission rate of data to be recorded or reproduced, as will later be described in detail, on playback (PB) it has a frequency equal to that of the output frequency signal FG from the frequency generator 22 when the disc 11 is rotated at a desired rotational speed. The speed reference signal REF can be substituted by a frequency signal obtained by dividing the frequency of the signal FG. In this case, the output signal FG should also be divided by the same dividing ratio before being supplied to the phase comparator circuit 23.

An output signal from the phase comparator circuit 23 indicative of the comparison result is integrated by an integrator circuit 24 to provide a speed error signal indicative of the difference between the speed reference signal REF and the actual rotational speed of the motor 21. The speed error signal is fed back to the motor 21 through a motor drive 25 so that the motor 21 rotates at an angular velocity corresponding to the speed reference signal REF.

Reference is now made to a recording system part of the apparatus. An input terminal 31D is provided to receive digital signals such as data from a computer or time sampled analog data, for example, analog audio data sampled at various predetermined sampling frequencies with each value being sampled as one word composed of a predetermined number of bits, digital data at various data transmission rates, or the like. An input terminal 31A is provided to receive analog signals, such as audio signals.

Digital data input to the terminal 31D is supplied direct to a selector 33 while analog signals input to the terminal 31A are first supplied to an analog-to-digital (A/D) converter 32 to be converted into corresponding digital signals. The sampling frequency of the A/D converter 32 can be changed between various values, for example 32 kHz, 44.1 kHz, 48 kHz, and the like. Further, it is possible that the sample bit number can be selected from various numbers of bits, for example 8 bits, 12 bits, 16 bits, and the like. In the case of such digitally converted analog signals, particularly in the case of digitally converted audio signals, the resulting signal has a correlation among data words so that an erroneous word can be interpolated using other words located in the vicinity of the erroneous word. This is because the changes in amplitude of an analog signal are not likely to be as abrupt as in the case of a digitally generated signal. The digital signal from the A/D converter 32 is also supplied to the selector 33.

The selector 33 selects, by either manual operation or a control signal supplied thereto from an external circuit (not shown), the digital signals from either the input terminal 31D or the A/D converter 32. The digital signal selected by the selector 33 is then supplied to an ECC encoder 34, wherein the data is transformed into a product-coded block of data (for example 512 bytes) to be recorded in one sector on the track of the disc-shaped recording medium 11, according to the method heretofore described. The data processed by the ECC encoder 34 is supplied to a recording means 35 to be suitably modulated. The output of the recording means 35 is supplied to the head as serial data and is then recorded on the magneto-optical disc 11.

At that time, the rotational speed of the disc 11 is controlled so as to be synchronised with the transmission rate of the digital data to be recorded. The switch 26 is changed over to a recording (REC) terminal side so that a speed reference signal generated from a speed reference signal generator circuit 36 is supplied to the phase comparator circuit 23 as the speed reference signal REF.

If the data to be recorded is a digital signal from the input terminal 31D and if the data is self-clocking, the data from the input terminal 31D is supplied to the speed reference signal generator circuit 36, wherein a clock signal is extracted from the data, the transmission rate is calculated on the basis of the clock signal, and a speed reference signal corresponding to the calculated transmission rate is generated by the circuit 36.

On the other hand, if data from the input terminal 31D is not self-clocking data, that is, if a signal indicative of the transmission rate of the data such as a clock signal is sent separately from the data, the separate signal indicative of the transmission rate is supplied through an input terminal 31R to the speed reference signal generator circuit 36 which then generates a speed reference signal corresponding to the transmission rate obtained from the separate signal indicative of the transmission rate.

If the data to be recorded is an analog signal input via the input terminal 31A and converted into digital data by the A/D converter 32, a switch 37 is changed over according to the aforementioned sampling frequency and the bit number of one word length which has been selected, so that a speed reference signal corresponding to the transmission rate is generated by the speed reference signal generator circuit 36.

Assuming, for example, that a non-self-clocking, digital signal having a known transmission rate is input to the terminal 31D but the signal indicative of the transmission rate is not transmitted, in this case a speed reference signal corresponding to the known transmission rate can be selected by the switch 37.

The motor 21 is driven in a manner such that the phase (frequency) of the speed reference signal corresponding to the transmission rate of the input data and that of the frequency signal FG generated by the frequency generator 22 coincide with each other, and accordingly the disc 11 is rotated at a rotational speed in synchronism with the transmission rate of the input data.

The signal indicative of the transmission rate of the data from the signal generator circuit 36 is also supplied to the ECC encoder 34 and then recorded on the disc 11 as a portion of the supplementary data SUPD. Also recorded as a portion of the supplementary data SUPD are the sampling frequency and the bit number forming one word length of the data.

If an ECC-encoded digital signal with parity and other redundancy bits is input to the terminal 31D, it is necessary to decode the signal to reduce it to only inherent digital data.

The data indicative of the transmission rate of the recorded data may be recorded in a directory area which may be allocated in the innermost track or the outermost track of the disc.

A reproducing system part of the apparatus will now be described with reference to Figure 4.

A digital signal reproduced from the disc 11 by an optical reproducing head (not shown) is supplied to a reproducing means 41 to be demodulated. The digital signal from the reproducing means 41 is then supplied to a supplementary data decoder 46 wherein the signal indicative of the transmission rate (recorded in the supplementary data area of each sector) is decoded. A speed reference signal generator circuit 47 is supplied with the decoded signal indicative of the transmission rate, allowing a corresponding speed reference signal to be generated. The speed reference signal is in turn supplied to the phase comparator circuit 23 through a playback terminal side PB of the switch 26. Thus the disc 11 is rotated at a rotational speed in synchronism with the transmission rate of the recorded data.

The speed reference signal for controlling the rotation of the disc upon playback or reproduction can be generated by previously reading, prior to data reproduction, the data indicative of the transmission rate which is recorded in the directory area of the disc. Moreover, if the transmission rate recorded on the disc is stored in a memory or the like, it is of course possible to change the speed reference signal manually.

The data thus reproduced from the disc 11 rotating at a rotational speed in synchronism with the data transmission rate is supplied from the reproducing means 41 to an ECC decoder 42. The ECC decoder carries out error correction and the like for each sector and then reduces the data to only inherent data, namely with redundancy data removed. If the reproduced data thus processed is original digital data, the data is delivered to an output terminal 45D via a multiplexer 43. On the other hand, if the reproduced data is digital data converted from an analog signal, the data is supplied to a digital-to-analog (D/A) converter 44 to be reconverted into an analog signal before being delivered to an output terminal 45A.

The data required to effect D/A conversion in the D/A converter 44, namely the sampling frequency and the bit number of one word of data, can be previously known by decoding the supplementary data or reading the data recorded in the directory area. The D/A conversion can then be effected in response to this known data.

In this embodiment, the driving motor 21, and therefore also the rotation of the disc 11, is controlled to rotate at a constant angular velocity. However, the above-described technique can be applied to the case where the driving motor 21 is controlled to rotate the disc 11 at a constant linear velocity.

As described above, when the size of a block containing data to be transmitted is varied, the present method adjusts to this variation in the block size by altering the number of data words in one direction (the column direction) of the rectangular array while keeping the number of data words in the other direction (the row direction) the same. According to this method, although different sizes of blocks are to be transmitted, these blocks are reformed into blocks containing the same quantity of data, and some of the same error correcting codes (for example, the C₁ parity) are generated for each reformed block. It is therefore possible to utilise common hardware, such as the C₁ error code generator, even when different sized blocks of data are to be transmitted. Also, when the transmitted data is decoded, it is possible to utilise a common error correcting process in which possible errors occurring in the transmitted data are corrected by the use of the same error correcting codes (for example, the C₁ parity).

Further, while in all of the above examples the number of data words has been increased, it should be apparent that the reverse process is also possible. Thus, an array of 1056 bytes of data (as shown in Figure 1B) can be reformed as two 740 byte arrays (as shown in Figure 1A).

## Claims

1. A data transmission or recording method for data formed in a rectangular array of rows and columns comprising a block of data formed of a predetermined number n of words, supplementary data (SUPD) associated with said block of data and an error detecting code (EDC) to detect possible errors which may occur in said block of data and said supplementary data, said method comprising the steps of:
producing and adding a first error correcting code (C₁) for and to each row of data of said rectangular array along which said data of n words is sequentially arranged;
producing and adding a second error correcting code (C₂) for and to each column of data of said rectangular array thereby to form product-coded data from said block of data, said supplementary data (SUPD), said first error correcting code (C₁) and said second error correcting code (C₂); and
fetching and either transmitting or recording said product-coded data along each said row;
characterised in that:
when said block of data is to be changed in word number from the number n to a selected number m, the number of data in each said column of said rectangular array is varied in response to the change in data word number while the number of data words in each said row is fixed so as to form a new rectangular array of product-coded data; and
the new product-coded data forming said new rectangular array is sequentially fetched and either transmitted or recorded along each said row.

2. A method according to claim 1, wherein said block of data is formed of a digitally converted audio signal which has a correlation among the data words and in which an erroneous word can be interpolated by words located in the vicinity of said erroneous word.

3. A method according to claim 1, wherein said block of data does not have any correlation among the data words so that an erroneous word cannot be interpolated by words located in the vicinity of said erroneous word.

4. A method according to claim 1, claim 2 or claim 3, wherein the data is sequentially recorded on a multi-sectored disc-shaped recording medium (11), and the product-coded data is recorded in each sector of the recording medium (11), each of said sectors having a capacity for recording product-coded data formed of either n words or m words.

5. A method according to claim 4, wherein the data may be recorded on one of a plurality of different types of multi-sectored disc-shaped recording media (11), a first said type of recording medium (11) having a capacity in each sector for recording product-coded data formed of n words and a second said type of recording medium (11) having a capacity in each sector for recording product-coded data formed of m words.

6. A method according to any one of claims 1 to 5, wherein said or each said rectangular array is formed such that the supplementary data (SUPD) is followed by a block of data formed of a predetermined number of data words which, in turn, is followed by said error detecting code (EDC).

7. A method according to any one of claims 1 to 5, wherein said or each said rectangular array is formed such that said block of data formed of a predetermined number of words is followed by said supplementary data (SUPD) and said error detecting code (EDC).

8. A method according to claim 7, wherein said supplementary data (SUPD) is placed after said block of data and said error detecting code (EDC) is placed after said supplementary data (SUPD).

9. A method according to any one of the preceding claims, wherein said supplementary data (SUPD) includes information indicative of the transmission rate of said block of data.

10. A method according to any one of the preceding claims, wherein said supplementary data (SUPD) includes information indicative of a sampling frequency of said block of data.

11. A method according to any one of the preceding claims, wherein said supplementary data (SUPD) includes information indicative of whether or not an erroneous word in said block of data can be interpolated.

12. A method according to any one of the preceding claims, wherein the number m is an integer multiple of the number n.

13. A method according to claim 12, wherein the number n is 512 and the number m is 1024.

14. A method according to any one of the preceding claims, wherein the corresponding rows of all arrays of product-coded data have the same first error correcting codes (C₁).

## Patentansprüche

1. Verfahren zum Übertragen oder Aufzeichnen von Daten, die in einem rechteckförmigen Feld von Reihen und Spalten angeordnet sind, das einen Block von Daten umfaßt, der aus einer vorbestimmten Anzahl n von Wörtern, ergänzenden Daten (SUPD), die dem Block von Daten zugeordnet sind, und einem Fehlererfassungskode (EDC) zum Erfassen möglicher Fehler, die in dem Block von Daten und den ergänzenden Daten auftreten können, gebildet ist, welches Verfahren Schritte umfaßt zum
Erzeugen und Addieren eines ersten Fehlerkorrekturkodes (C₁) für und zu jeder Reihe von Daten des rechteckförmigen Feldes, längs welchem die Daten von n Wörtern sequentiell angeordnet sind,
Erzeugen und Addieren eines zweiten Fehlerkorrekturkodes (C₂) für und zu jeder Spalte aus dem Block von Daten des rechteckförmigen Feldes, um dadurch produktkodierte Daten aus dem Block von Daten, den ergänzenden Daten (SUPD), dem ersten Fehlerkorrekturkode (C₁) und dem zweiten Fehlerkorrekturkode (C₂) zu bilden, und Abrufen und entweder Übertragen oder Aufzeichnen der produktkodierten Daten längs jeder der Reihen,
dadurch **gekennzeichnet,** daß
wenn der Block von Daten in der Wortanzahl von der Anzahl n zu einer ausgewählten Anzahl m zu ändern ist, die Anzahl von Daten in jeder Spalte des rechteckförmigen Feldes in Reaktion auf die Änderung der Datenwortanzahl geändert wird, während die Anzahl von Datenwörtern in jeder Reihe festgelegt ist, um so ein neues rechteckförmiges Feld von produktkodierten Daten zu bilden, und
die neuen produktkodierten Daten, welche das neue rechteckförmige Feld bilden, sequentiell abgerufen und längs jeder der Reihen entweder übertragen oder aufgezeichnet werden.

2. Verfahren nach Anspruch 1, bei dem der Block von Daten aus einem digital umgesetzten Audiosignal gebildet ist, das eine Korrelation unter den Datenwörtern hat und in dem ein fehlerhaftes Wort durch Wörter interpoliert werden kann, die in der Nachbarschaft des fehlerhaften Wortes liegen.

3. Verfahren nach Anspruch 1, bei dem der Block von Daten keinerlei Korrelation unter den Datenwörtern hat, so daß ein fehlerhaftes Wort nicht durch Wörter interpoliert werden kann, die in der Nachbarschaft des fehlerhaften Wortes liegen.

4. Verfahren nach Anspruch 1, 2 oder 3, bei dem die Daten sequentiell auf einem plattenförmigen Vielsektor-Aufzeichnungsmedium (11) aufgezeichnet werden und die produktkodierten Daten in jedem Sektor des Aufzeichnungsmediums (11) aufgezeichnet werden, wobei jeder der Sektoren eine Kapazität zum Aufzeichnen von produktkodierten Daten hat, die aus entweder n Wörtern oder m Wörtern gebildet sind.

5. Verfahren nach Anspruch 4, bei dem die Daten auf einer Vielzahl von unterschiedlichen Arten von plattenförmigen Vielsektor-Aufzeichnungsmedien (11) aufgezeichnet werden können, wobei eine erste Art von Aufzeichnungsmedium (11) eine Kapazität in jedem Sektor zum Aufzeichnen von produktkodierten Daten hat, die aus n Wörtern gebildet sind, und eine zweite Art von Aufzeichnungsmedium (11) eine Kapazität in jedem Sektor zum Aufzeichnen produktkodierter Daten hat, die aus m Wörtern gebildet sind.

6. Verfahren nach einem der Ansprüche 1 bis 5, bei dem das oder jedes rechteckförmige Feld derart gebildet ist, daß den ergänzenden Daten (SUPD) ein Block von Daten folgt, der aus einer vorbestimmten Anzahl von Datenwörtern gebildet ist, welchem seinerseits der Fehlerkorrekturkode (EDC) folgt.

7. Verfahren nach einem der Ansprüche 1 bis 5, bei dem das oder jedes rechteckförmige Feld derart gebildet ist, daß dem Block von Daten, der aus einer vorbestimmten Anzahl von Wörtern gebildet ist, die ergänzenden Daten (SUPD) und der Fehlererfassungskode (EDC) folgen.

8. Verfahren nach Anspruch 7, bei dem die ergänzenden Daten (SUPD) nach dem Block von Daten plaziert sind und der Fehlererfassungskode (EDC) nach den ergänzenden Daten (SUPD) plaziert ist.

9. Verfahren nach einem der vorhergehenden Ansprüche, bei dem die ergänzenden Daten (SUPD) Information enthalten, die bezeichnend für die Übertragungsrate des Blocks von Daten ist.

10. Verfahren nach einem der vorhergehenden Ansprüche, bei dem die ergänzenden Daten (SUPD) Information enthalten, die bezeichnend für eine Abtastfrequenz des Blocks von Daten ist.

11. Verfahren nach einem der vorhergehenden Ansprüche, bei dem die ergänzenden Daten (SUPD) Information enthalten, die bezeichnend dafür ist, ob ein fehlerhaftes Wort in dem Block von Daten interpoliert oder nicht interpoliert werden kann.

12. Verfahren nach einem der vorhergehenden Ansprüche, bei dem die Anzahl m ein ganzzahliges Vielfaches der Anzahl n ist.

13. Verfahren nach Anspruch 12, bei dem die Anzahl n 512 beträgt und die Anzahl m 1024 beträgt.

14. Verfahren nach einem der vorhergehenden Ansprüche, bei dem die sich entsprechenden Reihen aller Felder von produktkodierten Daten dieselben ersten Fehlerkorrektorkodes (C1) haben.

## Revendications

1. Méthode de transmission ou d'enregistrement de données pour des données formées en une matrice rectangulaire de lignes et de colonnes comprenant un bloc de données constitué d'un nombre n prédéterminé de mots, des données supplémentaires (SUPD) associées audit bloc de données et un code de détection d'erreurs (EDC) pour détecter les erreurs possibles qui peuvent se produire dans ledit bloc de données et dans lesdites données supplémentaires, ladite méthode comprenant les étapes qui consistent à:
produire et ajouter un premier code de correction d'erreurs (C₁) pour et à chaque ligne de données de ladite matrice rectangulaire le long de laquelle lesdits n mots de données sont séquentiellement disposés;
produire et ajouter un second code de correction d'erreurs (C₂) pour et à chaque colonne de données de ladite matrice rectangulaire pour former ainsi des données de code de produit à partir dudit bloc de données, desdites données supplémentaires (SUPD), dudit premier code de correction d'erreurs (C₁) et dudit second code de correction d'erreurs (C₂); et à
prendre en charge et soit transmettre, soit enregistrer lesdites données de code de produit le long de chaquedite ligne;
caractérisée en ce que:
quand ledit bloc de données doit avoir son nombre de mots changé du nombre n à un nombre m sélectionné, le nombre de données dans chaquedite colonne de ladite matrice rectangulaire est changé en réponse au changement du nombre de mots de données alors que le nombre de mots de données dans chaquedite ligne est fixe, de manière à former une nouvelle matrice rectangulaire de données de code de produit; et
les nouvelles données de code de produit constituant ladite nouvelle matrice rectangulaire sont prises en charge séquentiellement et soit transmises, soit enregistrées le long de chaquedite ligne.

2. Méthode selon la revendication 1, dans laquelle ledit bloc de données est constitué par un signal audio converti en numérique qui implique une corrélation entre les mots de données et dans lequel un mot erroné peut être soumis à une interpolation au moyen de mots situés au voisinage dudit mot erroné.

3. Méthode selon la revendication 1, dans laquelle ledit bloc de données n'implique pas de corrélation entre les mots de données, de sorte qu'un mot erroné ne peut pas être soumis à une interpolation au moyen de mots situés au voisinage dudit mot erroné.

4. Méthode selon l'une quelconque des revendications 1 à 3, dans laquelle les données sont séquentiellement enregistrées sur un support d'enregistrement sous forme de disque à plusieurs secteurs (11), et les données de code de produit sont enregistrées dans chaque secteur du support d'enregistrement (11), chacun desdits secteurs ayant une capacité pour enregistrer des données de code de produit constituées soit de n mots, soit de m mots.

5. Méthode selon la revendication 4, dans laquelle les données peuvent être enregistrées sur un d'une pluralité de différents types de supports d'enregistrement sous forme de disques à plusieurs secteurs (11), undit premier type de support d'enregistrement (11) ayant une capacité dans chaque secteur pour enregistrer des données de code de produit constituées de n mots et undit second type de support d'enregistrement (11) ayant une capacité dans chaque secteur pour enregistrer des données de code de produit constituées de m mots.

6. Méthode selon l'une quelconque des revendications 1 à 5, dans laquelle ladite ou chaquedite matrice rectangulaire est formée de telle sorte que les données supplémentaires (SUPD) sont suivies par un bloc de données constitué d'un nombre prédéterminé de mots de données qui est à son tour suivi par ledit code de détection d'erreurs (EDC).

7. Méthode selon l'une quelconque des revendications 1 à 5, dans laquelle ladite ou chaquedite matrice rectangulaire est formée de telle sorte que ledit bloc de données constitué d'un nombre prédéterminé de mots est suivi par lesdites données supplémentaires (SUPD) et ledit code de détection d'erreurs (EDC).

8. Méthode selon la revendication 7, dans laquelle lesdites données supplémentaires (SUPD) sont placées après ledit bloc de données et ledit code de détection d'erreurs (EDC) est placé après lesdites données supplémentaires (SUPD).

9. Méthode selon l'une quelconque des revendications 1 à 8, dans laquelle lesdites données supplémentaires (SUPD) comprennent des informations indiquant le débit de transmission dudit bloc de données.

10. Méthode selon l'une quelconque des revendications 1 à 9, dans laquelle lesdites données supplémentaires (SUPD) comprennent des informations indiquant une fréquence d'échantillonnage dudit bloc de données.

11. Méthode selon l'une quelconque des revendications 1 à 10, dans laquelle lesdites données supplémentaires (SUPD) comprennent des informations indiquant si un mot erroné dans ledit bloc de données peut ou non être soumis à une interpolation.

12. Méthode selon l'une quelconque des revendications 1 à 11, dans laquelle le nombre m est un entier, multiple de n.

13. Méthode selon la revendication 12, dans laquelle le nombre n est égal à 512 et le nombre m égal à 1024.

14. Méthode selon l'une quelconque des revendications 1 à 13, dans laquelle les lignes correspondantes de toutes les matrices - de données de code de produit comportent les mêmes premiers codes de correction d'erreurs (C₁).
